# EUROPEAN PATENT SPECIFICATION

(11) **EP 1 385 201 B1**
(45) Date of publication and mention of the grant of the patent: **05.09.2012**
(21) Application number: 03016761.3
(22) Date of filing: 23.07.2003
(51) Int. Cl.: H01L 21/768

(54) **Method of fabricating dual damascene interconnections of microelectronic device**
Herstellung von Doppel-Damaszener Verbindungen eines mikroelektronischen Bauelementes
Méthode de formation des interconnexions en double-damasquinage d'un dispositif micro-électronique

(30) Priority: 24.07.2002 KR 2002043477; 03.07.2003 KR 2003044852
(43) Date of publication of application: 28.01.2004
(73) Proprietor: Samsung Electronics Co., Ltd., Suwon-City, Kyungki-do (KR)
(72) Inventor: Lee, Kyoung-woo, Youngdeungpo-gu, Seoul (KR); Lee, Soo-geun, Suwon-City, Kyungki-do (KR); Park, Wan-jae, Suwon-City, Kyungki-do (KR); Kim, Jae-hak, Songpa-gu, Seoul (KR)
(74) Representative: Patentanwälte Ruff, Wilhelm, Beier, Dauster & Partner

(56) References cited:
- US-A- 5 364 813
- US-A- 6 030 901
- US-A- 6 057 239
- US-A- 6 127 089
- US-A1- 2001 027 002
- US-B1- 6 168 726
- US-B1- 6 211 068
- US-B1- 6 348 736
- US-B1- 6 362 109
- US-B1- 6 461 955
- PATENT ABSTRACTS OF JAPAN vol. 2000, no. 15, 6 April 2001 (2001-04-06) -& JP 2000 340649 A (TEXAS INSTR INC <TI>), 8 December 2000 (2000-12-08)

## Description

The present invention relates to a microelectronic device, and more particularly, to a method of fabricating dual damascene interconnections of a microelectronic device.

As microelectronic devices become more efficient and highly integrated, multi-layered interconnections are more widely used. To obtain a reliable device including multi-layered interconnections, each interconnection layer are formed in a planar fashion. Thus, dual damascene interconnections have become strongly relied upon.

Meanwhile, in today's highly integrated microelectronic devices, a design rule has been reduced to 0.18 µm or less, and even to 90 nm. Such a small design rule brings about increases in RC delay, cross talk, and power consumption. To solve these problems, an interlayer dielectric (ILD) should be formed of a low-k dielectric material layer. As a result, the need to further develop techniques of fabricating dual damascene interconnections using a low-k ILD has greatly increased.

Methods of fabricating dual damascene interconnections are disclosed in U.S. Patent No. 6,057,239, and in J. Vac. Sci. Technol. A19 (2001) p. 1388, by P. Jiang et al. However, the method disclosed in U.S. Patent No. 6,057,239 uses an ILD formed of only an oxide layer, a dielectric constant of which is about 4 to 4.3.

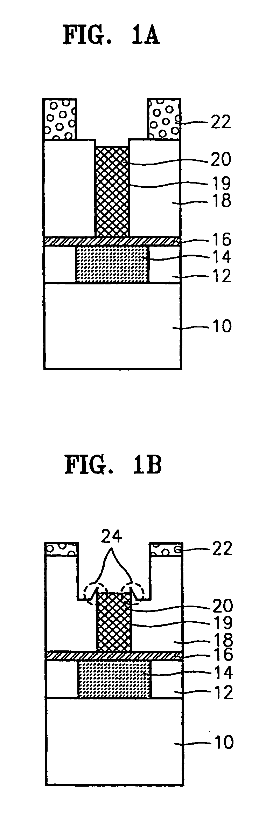

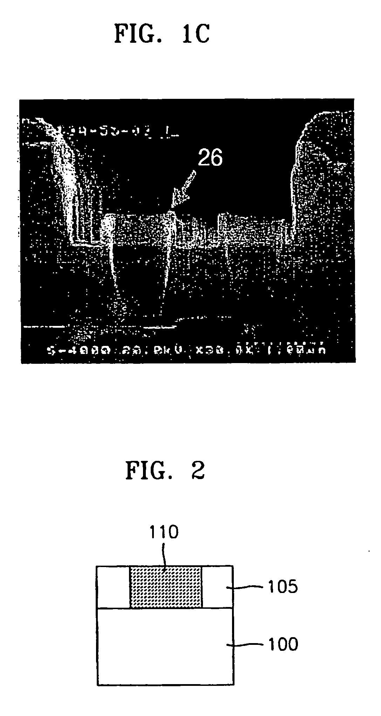

Also, when a trench is etched and cleaned, an etch stop layer may be etched to expose interconnections, thus degrading electrical properties of the interconnections. In the thesis by P. Jiang et al., before a trench is etched, a via is filled with an organic filler, such as a bottom anti-reflection layer (ARL), to prevent degradation of electrical properties. However, because both the organic filler and a photoresist pattern are organic materials having similar etch rates, the photoresist pattern is almost removed during etching of the organic filler formed on an ILD. Thus, when the ILD is etched to form a final trench, the photoresist pattern cannot be used as an etch mask. To prevent this problem, as shown in FIG. 1A, before a photoresist pattern 22 is formed, an organic filler 20 is etched using an etchback process until the organic filler 20 remains only in a via 19. However, this process is very complicated. In addition, as illustrated with dotted circles 24 in FIG. 1B, a low-k ILD 18 is not etched and remains on the organic filler 20 because of a difference in etch rate between the organic filler 20 and the low-k ILD 18. The remaining low-k ILD 18 generates fences 26 as shown in FIG. 1C. In FIGS. 1A and 1B, reference numeral 10 denotes a substrate, 12 denotes a lower ILD, 14 denotes lower interconnections, and 16 denotes an etch stop layer.

To prevent the fence defects, if the organic filler 20 is etched back by over-etching such that a portion of the via 19 is filled with the organic filler 20, a thickness deviation of a photoresist layer becomes very great between a high via-density region and a low via-density region. As a result, a depth of focus (DOF) margin decreases in a photolithographic process.

Further, during an exposure process for forming the photoresist pattern 22, basic materials, such as amine, may be diffused from the ILD 18 through the organic filler 20 to the photoresist layer, thereby resulting in photoresist poisoning.

JP 2000-340649 A1 disposes a method of fabricating dual damascene interconnections by forming a dielectric layer over a semiconductor body, forming a via therein, forming a via protect layer in said via using a material having a wet etch selectivity of approximately 100 or more times that of the dielectric layer and a dry etch selectivity of at least that of the dielectric layer, forming a trench pattern of said dielectric layer, etching a trench through a portion of said dielectric layer including to remove a portion of said via protect layer, selectively removing any remaining portion of the via protect layer, and forming a metal layer in said via and said trench. In this prior art method the dielectric layer may include an organo silicate glass material, and the via protect layer may include a HydrogenSilsesQuioxane (HSQ) material. At the time of forming the trench pattern the via protect layer is present in the via only. For example, the via protect layer may be blanket deposited and then selectively etched back making use of the specificially chosen etch selectivity rates with respect to the dielectric layer.

It is the technical problem underlying the present invention to provide a method of fabricating reliable and non-defective dual damascene interconnections without degrading electrical properties of a low-k ILD.

The present invention solves this problem by providing a method of fabricating dual damascene interconnections according to the features of claim 1.

Some of these features are forming a hybrid dielectric layer having a dielectric constant of 3.3 or less or an organo silicate glass layer on a substrate; forming a via in the dielectric layer or organo silicate glass layer; forming carbon-free inorganic filler or HSQ-based filler which fills the via and laterally extends beyond a tip edge of the via; after forming the photoresist pattern, partially etching the filler filling the via and laterally extending beyond a top edge of the via, and the hybrid dielectric layer or organo silicate glass layer to form the trench, so as to be connected to the via, and the hybrid dielectric layer or organo silicate glass layer to form the trench so as to be connected to the via and in which interconnections will be formed; removing the filler remaining in the via; and completing interconnections by filling the trench and the via with an interconnection material.

Preferably, the organo silicate glass layer is formed using chemical vapor deposition (CVD) and may or may not be a hybrid dielectric layer having a dielectric constant of 3.3.

A method of fabricating dual damascene interconnections may comprise forming a lower interconnection on a substrate; forming an etch stop layer on the lower interconnection; forming an organo silicate glass layer using chemical vapor deposition (CVD) on the etch stop layer; forming a via through the organo silicate glass layer to expose the etch stop layer; filling the via with an HSQ-based filler; processing the surface of the HSQ-based filler using plasma; forming an anti-reflection layer (ARL) on the plasma-processed surface of the HSQ-based filler; partially etching the ARL, the HSQ-based filler filling the via, and the organo silicate glass layer to form a trench, which is connected to the via and in which interconnections will be formed; removing the HSQ-based filler remaining in the via; and completing interconnections by filling the trench and the vias with an interconnection material.

The foregoing and other objects, features and advantages of the invention will be apparent from the more particular description of a preferred embodiment of the invention, as illustrated in the accompanying drawings in which like reference characters refer to the same parts throughout the different views. The drawings are not necessarily to scale, emphasis instead being placed upon illustrating the principles of the invention.

FIGS. 1A through 1C are cross-sectional views and a scanning electron microscope (SEM) image illustrating a conventional method of fabricating conventional dual damascene interconnections.

FIGS. 2 through 13 are cross-sectional views illustrating a method of fabricating dual damascene interconnections according to an embodiment of the present invention.

FIGS. 14A, 14B, 15A, 16A, 17A, 17B, 18 and 19 are SEM images showing a test sample fabricated using features of the present invention.

FIGS. 15B and 16B are SEM images showing a contrastive sample according to a conventional method.

FIGS. 20 through 24 are graphs showing electrical properties of a device fabricated according the present invention.

In the present invention, an interlayer dielectric (ILD) is formed of a hybrid low-k dielectric material or an organo silicate glass layer. The hybrid low-k dielectric material has advantages of both organic and inorganic materials. The hybrid low-k dielectric material shows low-k characteristics like an organic material. Also, the hybrid low-k dielectric material can be formed using a conventional apparatus and process since it has a modified structure from a conventional inorganic silicate oxide. And, the hybrid low-k dielectric material is thermally stable like an inorganic material. In particular, by forming the ILD of a hybrid low-k dielectric material, whose dielectric constant is 3.3 or lower, RC delay is prevented and cross talk and power consumption can be minimized.

In the embodiments of the present invention, a via filler is formed of a material which has a good gap filling characteristic and which has an etch rate substantially equal to that of a low-k ILD, or has a high etch selectivity with respect to the low-k ILD, depending on etching methods or conditions. The via filler is formed of a carbon-free inorganic material so that it can be dry etched at the same etch rate as the ILD and wet etched at a much higher rate than the ILD. Also, the via filler material may function as a barrier layer to basic materials, such as nitrogen and amine. In specific embodiments of the present invention, a via filler material may comprise a light absorption material or a dissolution inhibitor for a photoresist developing solution. Thus, an etch stop layer for protecting a lower interconnection is not damaged, photoresist poisoning is prevented, a DOF margin is improved in a photolithographic process, and fence defects, which adversely affect electrical properties of dual damascene interconnections, are prevented. Further, robust and reliable dual damascene interconnections can be fabricated, without increasing the critical dimension of a trench.

The present invention can be applied to microelectronic devices, such as highly integrated circuit semiconductor devices, processors, micro electromechanical (MEM) devices, optoelectronic devices, and display devices. In particular, the present invention is highly useful for devices requiring high-speed characteristics, such as central processing units (CPUs), digital signal processors (DSPs), combinations of a CPU and a DSP, application specific integrated circuits (ASICs), logic devices, and SRAMs.

Herein, an opening exposing a lower interconnection is referred to as a via, and a region where interconnections will be formed is referred to as a trench. Hereinafter, the present invention will be described by a via-first dual damascene process, in which, even if misalignment occurs, the size of a via can be held constant.

Hereinafter, a method of fabricating dual damascene interconnections according to an embodiment of the present invention will be described with reference to FIGS. 2 through 13.

As shown in FIG. 2, a substrate 100 is prepared. A lower ILD 105 including a lower interconnection 110 is formed on the substrate 100. The substrate 100 may be, for example, a silicon substrate, a silicon on insulator (SOI) substrate, a gallium arsenic substrate, a silicon germanium substrate, a ceramic substrate, a quartz substrate, or a glass substrate for display. Various active devices and passive devices may be formed on the substrate 100. The lower interconnection 110 may be formed of various interconnection materials, such as copper, copper alloy, aluminium, and aluminium alloy. The lower interconnection 110 is preferably formed of copper because of its low resistance. Also, the surface of the lower interconnection 110 is preferably planarized.

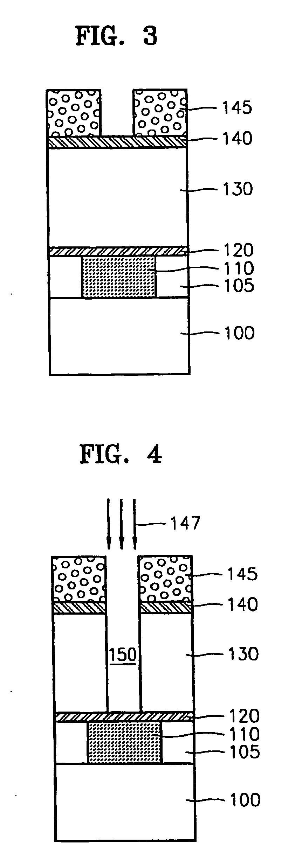

Referring to FIG. 3, an etch stop layer 120, a low-k ILD 130, and a capping layer 140 are sequentially stacked on the surface of the substrate 100 where the lower interconnection 110 is formed, and a photoresist pattern 145 is formed on the capping layer 140 to define a via.

The etch stop layer 120 is formed to prevent electrical properties of the lower interconnection 110 from being damaged during a subsequent dry etch process for forming a via and a subsequent wet etch process for removing the remaining filler. Accordingly, the etch stop layer 120 is formed of a material having a high etch selectivity with respect to the ILD 130 formed thereon. Preferably, the etch stop layer 120 is formed of SiC, SiN, or SiCN, having a dielectric constant of 4 to 5. The etch stop layer 120 is as thin as possible in consideration of the dielectric constant of the entire ILD, but thick enough to properly function as an etch stop layer.

The ILD 130 is formed of a hybrid low-k dielectric material, which has advantages of organic and inorganic materials. That is, the ILD 130 formed of the hybrid low-k dielectric material has low-k characteristics, can be formed using a conventional apparatus and process, and is thermally stable. The ILD 130 is formed of a hybrid material having a dielectric constant of 3.3 or less, to prevent an RC delay between the lower interconnection 110 and dual damascene interconnections and minimize cross talk and power consumption. Most preferably, the ILD 130 is formed of low-k organo silicate glass (OSG). The ILD 130 formed of low-k OSG can be formed using chemical vapor deposition (CVD), more specifically, plasma-enhanced CVD (PECVD). As the carbon content in an OSG layer increases, the dielectric constant of the OSG layer decreases but thermal and mechanical characteristics are degraded. However, if an OSG layer is formed using CVD, the carbon content in the OSG layer can be adjusted to appropriately control the dielectric constant and thermal and mechanical characteristics of the OSG layer. Therefore, an OSG layer formed using CVD is suitable for the ILD 130. It is obvious that various changes may be made by known methods in the source gas (e.g., carbon source gas, silicon source gas, and oxygen source gas), a CVD chamber, and fabricating conditions (e.g., temperature and time conditions) used for forming the OSG layer using CVD. A method of forming OSG using CVD may be a known method or methods disclosed in U.S. Patent No. 6,455,445, No. 6,432,846, No. 6,514,880, No. 6,559,520, No. 6,352,945, No. 6,383,955, and No. 6,410,463, and Korean Patent No. 0364053. The ILD 130 is formed to a thickness of 300 nm to 2000 nm, preferably, 600 nm to 700 nm. However, the ILD 130 can be formed to various thicknesses by those skilled in the art.

Meanwhile, when dual damascene interconnections are planarized using chemical mechanical polishing (CMP), the capping layer 140 prevents the ILD 130 from being damaged by the CMP. Thus, the capping layer 140 is formed of SiO₂, SiOF, SiON, SiC, SiN, or SiCN. Preferably, the capping layer 140 functions as an anti-reflection layer (ARL) in a subsequent photolithographic process for forming a trench. Accordingly, the capping layer 140 is more preferably formed of SiO₂, SiON, SiC, or SiCN.

The photoresist pattern 145 is formed by forming a layer of a photoresist that is suitable for a light source of 248 nm or less and then performing exposure and developing processes using a photo mask defining a via.

Referring to FIG. 4, the ILD 130 is dry etched (147) using the photoresist pattern 145 as an etch mask to form a via 150. The ILD 130 is etched using a reactive ion beam etch (RIE) process, which uses a mixture of a main etch gas (e.g., CₓF_{y} and CₓH_{y}F_{z}), an inert gas (e.g. Ar gas), and optionally at least one of O_{2,} N_{2,} and CO_{x.} Here, the RIE conditions are adjusted such that only the ILD 130 is selectively etched and the etch stop layer 120 is not etched.

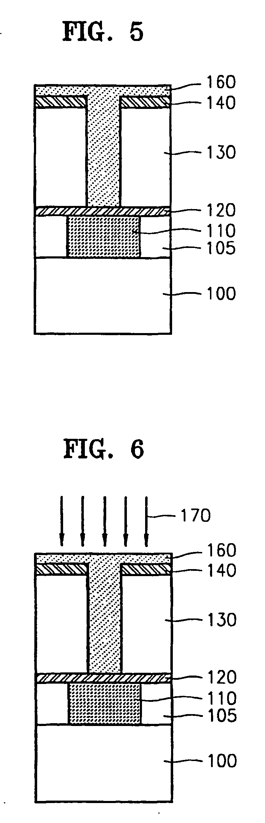

Referring to FIG. 5, the photoresist pattern 145 is removed and the via 150 is filled with a via filler 160. The photoresist pattern 145 is processed using an H₂-based plasma and removed using a stripper. H₂-based plasma refers to plasma obtained from H₂, N₂/H₂, NH₃/H₂, NH₃/H₂, He/H₂, or a mixture thereof. If the photoresist pattern 145 is removed using O₂-ashing, which is widely used for removing a photoresist pattern, the ILD 130 containing carbon to have organic properties may be damaged by the O₂-based plasma. Thus, the photoresist pattern 145 is preferably removed using an H2-based plasma.

The via filler 160 is formed of a material that has a good gap filling characteristic. Also, a dry etch ratio of the via filler 160 to the ILD 130 is either about 1:1 or 4:1 or less. Further, the via filler 160 is formed of a material that is etched at a higher etch rate than the ILD 130 in a subsequent wet etch process. Preferably, the via filler 160 is formed of a material having such a characteristic that a wet etch ratio of the via filler 160 to the ILD 130 is 20:1 or higher. Also, during an exposure process for forming a photoresist pattern to define a subsequent trench, basic materials, such as nitrogen and amine, included in the ILD 130, may diffuse into a photoresist layer. Thus, the via filler 160 is formed of a material that can prevent the diffusion of the basic material into the photoresist layer. That is, the via filler 160 is formed of a carbon-free inorganic material to have a dry etch rate being substantially equal to that of the ILD 130, which is a hybrid of an organic material and an inorganic material, and a wet etch rate being much higher than that of the ILD 130. Given the foregoing conditions, HydrogenSilsesQuioxane (HSQ) is the most suitable for the via filler 160 among carbon-free inorganic materials.

Further, the via filler 160 preferably includes a light absorption material or a dissolution inhibitor. The dissolution inhibitor, which inhibits dissolution of a photoresist developing solution, may be a material known by those skilled in the art. The functions of the light absorption material and the dissolution inhibitor will be described later. In the present invention, HSQ-based materials refer to not only pure HSQ but also HSQ including additives, such as a light absorption material and/or a dissolution inhibitor.

The via filler 160 is formed using spin coating to completely fill the via 150. While it is possible to fill only the via 150 with the via filler 160, the via filler 160 is formed on the capping layer 140 to a predetermined thickness in consideration of process margin control. Also, it is preferable in terms of a DOF margin that a difference between the height T1 of the via filler 160 formed in a low via-density region and the height T2 of the via filler 160 formed in a high via-density region is 200 nm or less. The thickness of HSQ-based materials can be easily controlled in consideration of variables such as coating recipe, the space between vias 150, the critical dimension, and the height of the via 150, and the condition (T1-T2≤200 nm) can be easily satisfied.

Referring to FIG. 6, the surface of the via filler 160 is processed using plasma 170. The plasma 170 is derived from O₂, H₂, He, NH₃, N₂, Ar, or any mixture thereof, and the plasma processing is conducted at a temperature of room temperature to 500°C for 1 to 120 seconds. The surface of the via filler 160 is densified by the plasma processing. Also, the plasma processing is carried out to prevent a photoresist developing solution from dissolving the via filler 160. Accordingly, if the via filler 160 includes a dissolution inhibitor, the plasma processing may be optionally omitted.

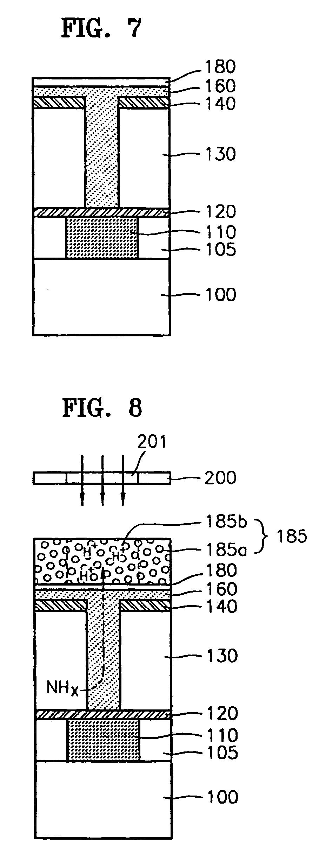

Referring to FIG. 7, an anti-reflection layer (ARL) 180 is formed on the via filler 160, which is processed using plasma 170. Although it is possible to form the ARL 180 using an inorganic material, the ARL 180 is preferably formed of an organic material in order to be easily removed later. The ARL 180 is formed of an anti-reflective material that can absorb light of a wavelength 248 nm, 193 nm, or less, which is known to those skilled in the art. The ARL 180 is formed to a thickness of 50 nm to 70 nm.

Referring to FIG. 8, a photoresist layer 185 is formed and then exposed to light using a mask 200 defining a trench. When the light emitted from an exposure source with a wavelength of 248 nm, 193 nm, or less is transmitted through a transmission region 201 of the mask 200 and radiated onto the photoresist layer 185, acids H+ are generated from a photo acid generator included in an exposure portion 185b of the photoresist layer 185. Here, the ARL 180, disposed under the exposure portion 185b, prevents rays penetrating the photoresist layer 185 from being reflected back to the photoresist layer 185. Accordingly, if the via filler 160 includes a light absorption material to prevent the reflection of rays, the formation of the ARL 180 may be optionally omitted. The acids H+ generated in the exposure portion 185b hydrolyze the photoresist layer 185 into a material soluble in a developing solution. After the exposure process, acidolysis becomes more active by a post-exposure baking (PEB) process. During the exposure process and the PEB process, the via filler 160 functions as a diffusion barrier layer to nitrogen or amine. Accordingly, basic materials, such as nitrogen and amine, which remain in the ILD 130 due to etch gas used for etching the via 150 as well as the plasma processing for removing the photoresist pattern (145 of FIG. 4) defining the via 150, cannot diffuse as depicted in a dotted line through the via filler 160 and neutralize the acids H+ generated in the exposure portion 185b, since the via filler 160 functions as the diffusion barrier layer, thereby resulting in no photoresist poisoning.

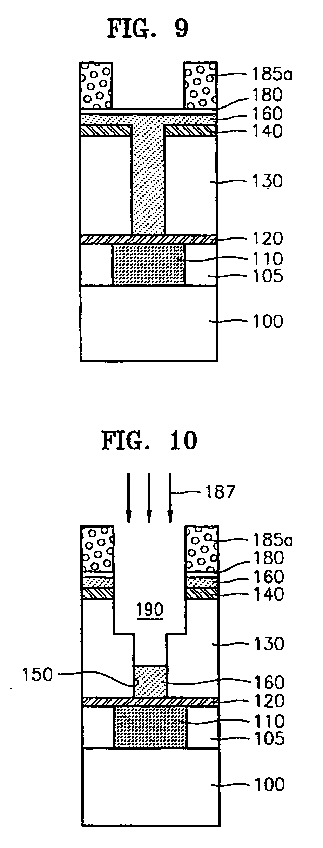

Referring to FIG. 9, a photoresist pattern 185a is formed. When the post-exposure baked photoresist layer 185 is soaked in a tetramethyl ammonium hydroxide developing solution, only the exposure portion 185b is dissolved in the developing solution. Thus, as shown in FIG. 9, the photoresist pattern 185a is obtained. Here, the via filler 160 is not exposed to the developing solution due to the ARL 180 disposed under the exposure portion 185b. If the via filler 160 is processed using plasma or includes a dissolution inhibitor, it is not damaged by the developing solution even without the ARL 180.

FIG. 10 shows the formation of a trench 190. The ARL 180, the via filler 160, and the capping layer 140 are sequentially etched using the photoresist pattern 185 as an etch mask, and then the ILD 130 and the via filler 160 are etched to a predetermined depth, thereby forming the trench 190. The trench 190 is dry etched on condition that an etch ratio of the via filler 160 to the ILD 130 is 1:1, or 4:1 or less. Therefore, fence defects (see FIG. 1) can be prevented and, since a portion of the via filler 160 still remains in the via 150, it can prevent the etch stop layer 120 from being etched to damage the lower interconnection 110. If the ILD 130 is formed of an OSG and the via filler 160 is formed of an HSQ-based material, both of them have characteristics of inorganic materials. Thus, if an RIE process is carried out using a mixture of a main etch gas (e.g., CₓF_{y} and CₓH_{y}F_{z}), an inert gas (e.g. Ar gas), and optionally at least one of O₂, N₂, and COx, the foregoing condition for etching the trench 190 can be satisfied.

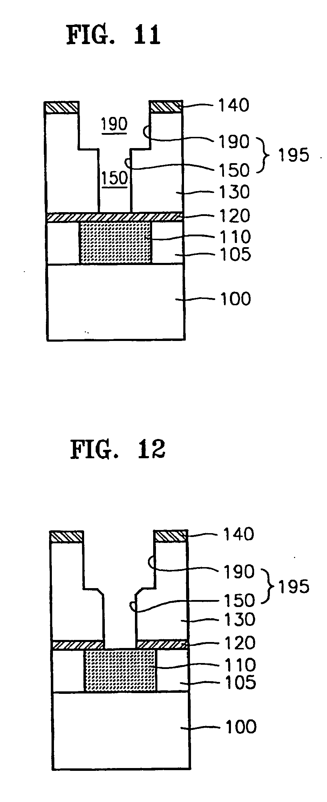

FIG. 11 is a cross-sectional view of the resultant structure, from which the photoresist pattern 185a and the remaining via filler 160 are removed. After the etching of the trench 190 is completed, the photoresist pattern 185a is removed using H2-based plasma obtained from H2, N2/H2, NH3/H2, NH3/H2, He/H2, or a mixture thereof. Next, the via filler 160 is removed, thereby forming a dual damascene interconnection region 195, which includes the via 150 and the trench 190. The via filler 160 is removed using a wet etch process. The wet etch process for removing the via filler 160 is carried out on condition that the ILD 130 is only slightly etched and only the via filler 160 is selectively removed, i.e., that a wet etch ratio of the via filler 160 to the ILD 130 is 20:1 or higher. Also, the via filler 160 should have an etch selectivity with respect to the etch stop layer 120. While the ILD 130 has organic characteristics, the via filler 160 and the etch stop layer 120 are formed of inorganic materials. Thus, to satisfy the condition, the via filler 160 is removed by wet etching using an etchant having a high selectivity with respect to organic materials. In particular, if the via filler 160 is formed of an HSQ-based material, the ILD 130 is formed of an OSG, and the etch stop layer 160 is formed of SiC(N), the via filler 160 may be wet etched in an HF solution diluted with deionized water (DIW), or a buffered oxide etchant (BOE), which is a mixture of NH_{4,} HF, and deionized water. Preferably, the diluted HF solution is in a ratio of 100 (DIW):1(HF) or higher. Thus, an etch ratio of HSQ-based material to OSG to SiC(N) can be higher than 100:1:1. In addition, etching of the ILD 130 can be prevented during the removal of the via filler 160 so as to precisely control the critical dimension of the trench 190.

A detailed description of the via etching, the trench etching, and the wet etching is given in Korean Patent Application No. 2002-57192, commonly owned by the same assignee.

Referring to FIG. 12, the etch stop layer 120 exposed in the via 150 is etched until the lower interconnection 110 is exposed, thereby completing the dual damascene interconnection region 195. The etch stop layer 120 is etched so that the lower interconnection 110 is not affected and only the etch stop layer 120 is selectively removed.

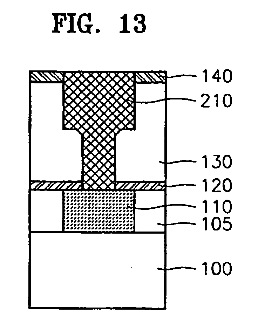

Referring to FIG. 13, a conductive layer is formed on the dual damascene interconnection region 195 and then planarized, thereby forming a dual damascene interconnection 210. The conductive layer is formed of aluminum, tungsten, copper, or any alloy thereof, and most preferably formed of copper because of its low resistance. Also, the conductive layer may be a stack of a diffusion barrier layer and a main interconnection layer, or may be embodied in various other forms by known methods.

The following experimental examples were obtained in a process of fabricating dual damascene interconnections of a 90 nm-design-rule logic device with embedded 1.1µm² 6Tr-SRAM.

### Experimental example 1

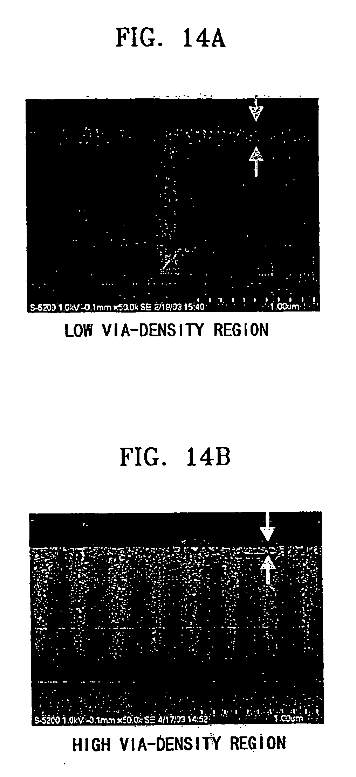

An etch stop layer was formed using SiC(k=5.0), an ILD was formed of CVD OSG(k=2.9) to a thickness of 700 nm, and a via having a diameter of 0.132 µm was formed. Next, HSQ(Fox™ of Dow Corning Corp.) for a via filler was formed using spin coating. FIGS. 14A and 14B are SEM images showing cross-sectional views of a test sample, in which the HSQ via filler is filled. Referring to FIGS. 14A and 14B, it can be seen that the HSQ had a good gap filling characteristic and was formed in a planar fashion on an OSG layer. Also, a difference between the thickness T1 (FIG. 14A) of the HSQ layer formed in the low via-density region and the thickness T2 (FIG. 14B) of the HSQ layer formed in the high via-density region was 200 nm or less.

### Experimental example 2

An HSQ layer was formed in the same manner as in Experimental example 1, and then an organic ARL and a photoresist for KrF were sequentially formed on the HSQ layer. An exposure process was conducted using an exposure source with a wavelength of 248 nm and a development process was carried out using a tetramethyl ammonium hydroxide developing solution, thereby forming a photoresist pattern defining a trench. As a result, a test sample was prepared.

A contrastive sample was prepared by forming a photoresist pattern defining a trench directly on an HSQ layer.

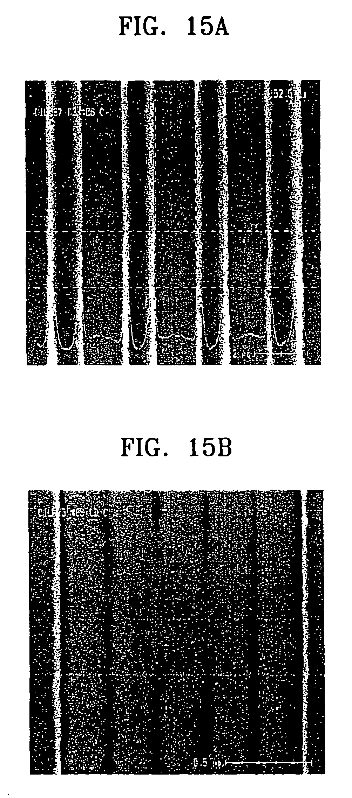

FIG. 15A is an SEM image of the test sample, while 15B is an SEM image of the contrastive sample. FIGS. 15A and 15B confirm that a reliable photoresist pattern was obtained by forming an organic ARL.

### Experimental example 3

An HSQ layer was formed in the same manner as in Experimental example 1, the surface of the HSQ layer was processed using plasma, and an organic ARL was formed. Next, a photoresist for KrF was coated on the organic ARL. An exposure process was conducted using an exposure source with a wavelength of 248 nm and a development process was carried out using a tetramethyl ammonium hydroxide developing solution, thereby forming a photoresist pattern defining a trench. As a result, a test sample was prepared.

A contrastive sample was prepared by using an organic ARL for a via filler in place of an HSQ layer and forming a photoresist pattern.

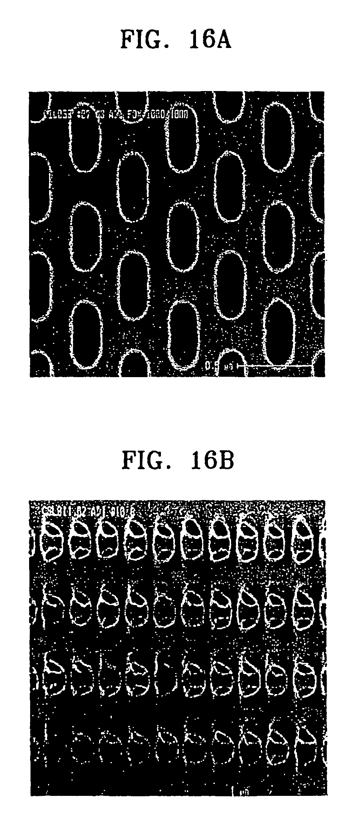

FIG. 16A is an SEM image of the test sample, while 16B is an SEM image of the contrastive sample. Referring to FIG. 16A, the HSQ via filler functioned as a diffusion barrier layer to basic materials, such as amine, so that a reliable photoresist pattern could be formed. In contrast, referring to FIG. 16B, when the organic ARL was used as the via filler, basic materials diffused and neutralized acids H+ in a photoresist layer, thereby forming a damaged photoresist pattern.

### Experimental example 4

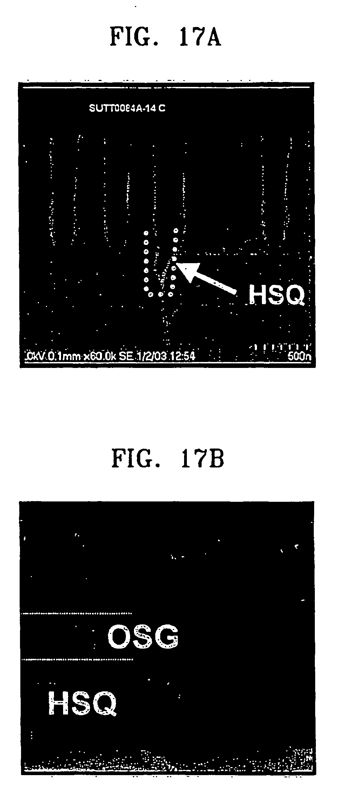

A photoresist pattern was formed in the same manner as in Experimental example 3, and a trench was formed by performing a dry etch process using a CₓF_{y} main etch gas such that an etch ratio of HSQ:OSG was 1:1. Thus, a test sample was prepared. FIGS. 17A and 17B are SEM images of the test sample. FIG. 17A is a cross-sectional view taken along the width of the trench, while FIG. 17B is a cross-sectional view taken along the length of the trench. Referring to FIGS. 17A and 17B, it can be seen that a good trench profile was formed in a dual damascene region, and although over-etching of about 50 % occurred, the HSQ via filler reliably protected a SiC etch stop layer.

### Experimental example 5

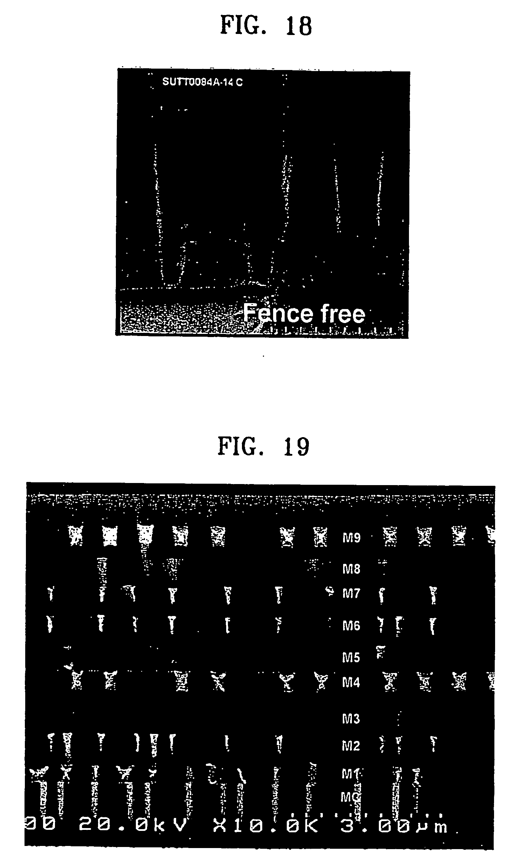

A trench was formed in the same manner as in Experimental example 4, an HSQ layer remaining in a via was removed using a diluted HF solution in a ratio of 500(DIW):1(HF). Thus, a test sample was prepared. FIG. 18 is an SEM image of the test sample. Referring to FIG. 18, the HSQ layer was completely removed, and a robust and reliable dual damascene region having a good profile and a desired critical dimension was formed without generation of fences.

### Experimental example 6

A dual damascene region was formed according to a process of fabricating a test sample as in Experimental examples 1 - 5, and a copper interconnection was formed in the dual damascene region, using a typical copper interconnection fabrication process. The dual damascene interconnection fabrication process was repeated two or more times, thereby completing 9-level dual damascene interconnections of a 90 nm-design-rule logic device with embedded 1.1 µm² 6Tr-SRAM. FIG. 19 is an SEM image of the logic device. FIG. 19 confirms that non-defective and reliable devices with a fine design rule can be fabricated.

### Experimental example 7

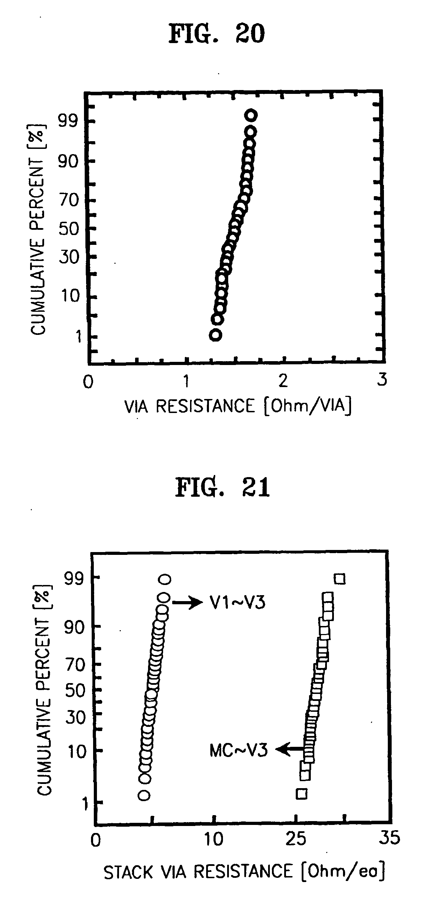

Electrical characteristics of the device fabricated in Experimental example 6 were measured. FIGS. 20 through 24 show the results.

Referring to FIGS. 20 and 21, it can be seen that the resulting dual damascene structure had good via resistance characteristics.

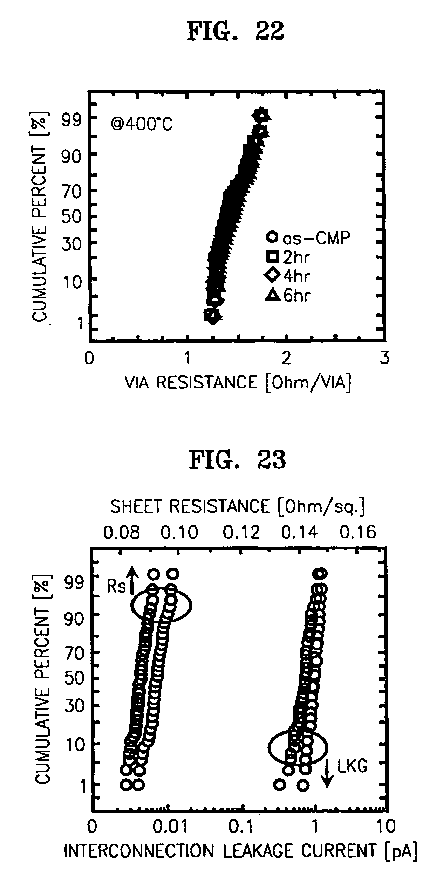

Referring to FIG. 22, it can be seen that even if the resulting device was annealed at a temperature of 400°C for 6 hours, the via resistance characteristics were not degraded.

In another method, a device was formed in the same manner as in Experimental example 6, except that the line and the space of interconnections were changed to 0.14 µm and 0.12µm, respectively. FIG. 23 shows results of measuring sheet resistance and leakage current of the interconnections.

Referring to FIG. 23, the sheet resistance and the leakage current were in good condition.

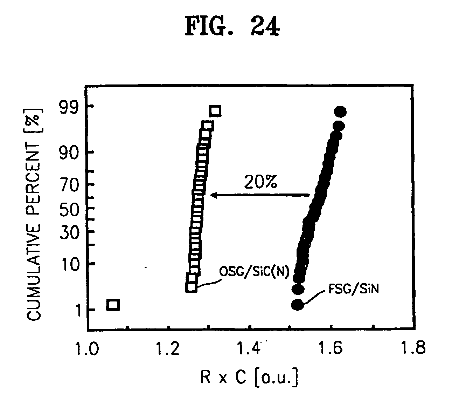

FIG. 24 shows an RC value of the device fabricated according to Experimental example 6 and an RC value of a device in which an etch stop layer is formed of SiN and an ILD is formed of SiOF.

Referring to FIG. 24, when the etch stop layer was formed of SiC and the ILD was formed of OSG, an RC value was reduced to about 20 % compared with the conventional device in which the etch stop layer is formed of SiN and the ILD is formed of SiOF.

According to features described, an ILD is formed of a low-k dielectric material such that an RC delay is prevented and cross talk and power consumption can be minimized. Also, the ILD is formed of a hybrid low-k dielectric material and a via filler is formed of a carbon-free inorganic material. As a result, an etch stop layer covering a lower interconnection is protected, photoresist poisoning is prevented, a DOF margin is improved in a photolithographic process, fences, which may adversely affect electrical properties of dual damascene interconnections, are prevented, and the width and the critical dimension of a trench can be held constant.

## Claims

1. A method of fabricating dual damascene interconnections, the method comprising:
(a) forming on a substrate (100) a hybrid dielectric layer (130) having a dielectric constant of 3.3 or less or an organo silicate glass layer and forming a capping layer (140) on the hybrid dielectric layer or organo silicate glass layer;
(b) forming a via (150) in the capping layer and the hybrid dielectric layer or organo silicate glass layer;
(c) forming a carbon-free inorganic filler or a HSQ-based filler (160) using spin coating which completely fills the via and is formed on the capping layer to a predetermined thickness;
(d) forming a photoresist pattern (185a) on the filler to define a trench (190);
(e) after forming the photoresist pattern, partially etching the filler, the capping layer and the hybrid dielectric layer or organo silicate glass layer to form the trench (190) by dry etching using the photoresist pattern as an etch mask such that an etch ratio of the filler to the hybrid dielectric layer or organo silicate glass layer is 4:1 or lower and so as to be connected to the via;
(f) removing the photoresist pattern and removing by wet etching the filler remaining in the via, while leaving the capping layer; and
(g) completing interconnections (210) by forming a conductive layer on the structure resulting from step (f) and planarizing the conductive layer using chemical mechanical polishing to fill the trench and the via with interconnection material, where the capping layer prevents the hybrid dielectric layer from being damaged by the chemical mechanical polishing.

2. The method of claim 1, further comprising, before step (a):
forming a lower interconnection (110) on the substrate; and
forming an etch stop layer (120) on the lower interconnection.

3. The method of claim 2, wherein the etch stop (120) layer is formed of at least one of SiC, SiN, and SiCN.

4. The method of any of claims 1 to 3, wherein the hybrid dielectric layer (130) having a dielectric constant of 3.3 or less is an organo silicate glass layer.

5. The method of any of claims 1 to 4, wherein the hybrid dielectric layer (150) having a dielectric constant of 3.3 or less is formed using chemical vapor deposition.

6. The method of any of claims 1 to 5, wherein the capping layer (140) is formed of an anti-reflective material.

7. The method of any of claims 1 to 6, wherein the capping layer (140) is formed of at least one of SiO₂, SiOF, SiON, SiC, SiN and SiCN.

8. The method of any of claims 1 to 7, wherein step (b) comprises:
forming a photoresist pattern (145) to define the via; and
forming the via exposing the etch stop layer (120) by dry etching the hybrid dielectric layer (130) or organo silicate glass layer using the photoresist pattern (145) as an etch mask.

9. The method of any of claims 1 to 8, wherein the carbon-free inorganic filler (160) is an HSQ -based filler.

10. The method of any of the claims 1 to 9, wherein the filler (160) further includes a light absorption material and/or a dissolution inhibitor for a photoresist developing solution.

11. The method of any of claims 1 to 10, further comprising, before step (d), at least one of (i) processing the surface of the filler (160) using plasma, (ii) forming an anti-reflection layer (180) on the surface of the filler (160), and (iii) processing the surface of the filler (160) using plasma and forming an anti-reflection layer (180) on the plasma-processed surface of the filler.

12. The method of claim 11, wherein the plasma is derived from O₂, H₂, He, NH₃, N₂, Ar, or any mixture thereof.

13. The method of claims 11 or 12, wherein the anti-reflection layer (180) is an organic anti-reflection layer.

14. The method of any of claims 11 to 13, wherein the anti-reflection layer (180) is formed to a thickness of about 50 nm to 70 nm.

15. The method of any of claims 1 to 14, wherein the dry etching uses CₓF_{y} or CₓH_{y}F_{z} as a main etching gas, and removing the photoresist pattern (145,185a) uses an H₂-based plasma.

16. The method of any of claims 1 to 15, wherein step (f) comprises wet etching such that an etch ratio of the filler (160) to the hybrid dielectric layer (130) or organo silicate glass layer is 20:1 or higher.

17. The method of claim 16, wherein the wet etching uses diluted HF or a mixture of NH₄F, HF, and deionized water.

18. The method of any of claims 1 to 17, wherein in step (g), the interconnection (210) is a copper interconnection.

19. The method of any of claims 1 to 18, wherein in step (a), the organo silicate glass layer (130) is formed using chemical vapor deposition.

## Patentansprüche

1. Verfahren zur Herstellung von Doppeldamaszener-Zwischenverbindungen, wobei das Verfahren umfasst:
(a) Bilden einer dielektrischen Hybridschicht (130) mit einer Dielektrizitätskonstanten von 3,3 oder weniger oder einer Organosilikatglasschicht auf einem Substrat (100) und Bilden einer Deckschicht (140) auf der dielektrischen Hybridschicht oder der Organosilikatglasschicht;
(b) Bilden eines Durchkontaktlochs (150) in der Deckschicht und in der dielektrischen Hybridschicht oder der Organosilikatglasschicht;
(c) Bilden einer kohlenstofffreien, anorganischen Füllung oder einer HSQ-basierten Füllung (160) mittels Aufschleuderbeschichten, welche das Durchkontaktloch vollständig füllt und in einer vorgegebenen Dicke auf der Deckschicht gebildet wird;
(d) Bilden eines Photoresistmusters (185a) auf der Füllung, um einen Graben (190) zu definieren;
(e) partielles Ätzen der Füllung, der Deckschicht und der dielektrischen Hybridschicht oder Organosilikatglasschicht nach dem Bilden des Photoresistmusters zur Bildung des Grabens (190) durch Trockenätzen unter Verwendung des Photoresistmusters als Ätzmaske derart, dass ein Ätzverhältnis der Füllung zur dielektrischen Hybridschicht oder Organosilikatglasschicht 4:1 oder weniger beträgt, und derart, dass er mit dem Durchkontaktloch verbunden ist;
(f) Entfernen des Photoresistmusters und Entfernen der im Durchkontaktloch verbliebenen Füllung mittels Nassätzen unter Beibehaltung der Deckschicht und
(g) Vervollständigen von Zwischenverbindungen (210) mittels Bilden einer leitfähigen Schicht auf der aus Schritt (f) resultierenden Struktur und Planarisieren der leitfähigen Schicht unter Verwendung von chemisch-mechanischem Polieren, um den Graben und das Durchkontaktloch mit Zwischenverbindungsmaterial zu füllen, wobei die Deckschicht die dielektrische Hybridschicht vor einer Schädigung durch das chemisch-mechanische Polieren schützt.

2. Verfahren nach Anspruch 1, weiter umfassend vor Schritt (a):
- Bilden einer unteren Zwischenverbindung (110) auf dem Substrat und
- Bilden einer Ätzstoppschicht (120) auf der unteren Zwischenverbindung.

3. Verfahren nach Anspruch 2, wobei die Ätzstoppschicht (120) aus wenigstens einem von SiC, SiN und SiCN gebildet wird.

4. Verfahren nach einem der Ansprüche 1 bis 3, wobei die dielektrische Hybridschicht (130) mit einer Dielektrizitätskonstanten von 3,3 oder weniger eine Organosilikatglasschicht ist.

5. Verfahren nach einem der Ansprüche 1 bis 4, wobei die dielektrische Hybridschicht (130) mit einer Dielektrizitätskonstanten von 3,3 oder weniger unter Verwendung einer chemischen Gasphasenabscheidung gebildet wird.

6. Verfahren nach einem der Ansprüche 1 bis 5, wobei die Deckschicht (140) aus einem Antireflexmaterial gebildet wird.

7. Verfahren nach einem der Ansprüche 1 bis 6, wobei die Deckschicht (140) aus wenigstens einem von SiO₂, SiOF, SiON, SiC, SiN und SiCN gebildet wird.

8. Verfahren nach einem der Ansprüche 1 bis 7, wobei der Schritt (b) umfasst:
- Bilden eines Photoresistmusters (145) zum Definieren des Durchkontaktlochs und
- Bilden des Durchkontaktlochs, das die Ätzstoppschicht (120) freilegt, mittels Trockenätzen der dielektrischen Hybridschicht (130) oder Organosilikatglasschicht unter Verwendung des Photoresistmusters (145) als Ätzmaske.

9. Verfahren nach einem der Ansprüche 1 bis 8, wobei die kohlenstofffreie, anorganische Füllung (160) eine HSQ-basierte Füllung ist.

10. Verfahren nach einem der Ansprüche 1 bis 9, wobei die Füllung (160) des Weiteren ein Lichtabsorptionsmaterial und/oder einen Lösungsinhibitor für eine Photoresistentwicklungslösung beinhaltet.

11. Verfahren nach einem der Ansprüche 1 bis 10, weiter umfassend vor Schritt (d) wenigstens eines von (i) Behandeln der Oberfläche der Füllung (160) mit einem Plasma, (ii) Bilden einer Antireflexschicht (180) auf der Oberfläche der Füllung (160) und (iii) Behandeln der Oberfläche der Füllung (160) unter Verwendung eines Plasmas und Bilden einer Antireflexschicht (180) auf der plasmabehandelten Oberfläche der Füllung.

12. Verfahren nach Anspruch 11, wobei das Plasma aus O₂, H₂, He, NH₃, N₂, Ar oder einer Mischung hiervon bereitet wird.

13. Verfahren nach Anspruch 11 oder 12, wobei die Antireflexschicht (180) eine organische Antireflexschicht ist.

14. Verfahren nach einem der Ansprüche 11 bis 13, wobei die Antireflexschicht (180) in einer Dicke von etwa 50 nm bis 70 nm gebildet wird.

15. Verfahren nach einem der Ansprüche 1 bis 14, wobei das Trockenätzen CₓF_{y} oder CₓH_{y}F_{z} als Hauptätzgas benutzt und das Entfernen des Photoresistmusters (145, 185a) ein H₂-basiertes Plasma verwendet.

16. Verfahren nach einem der Ansprüche 1 bis 15, wobei der Schritt (f) ein Nassätzen derart beinhaltet, dass ein Ätzverhältnis der Füllung (160) zur dielektrischen Hybridschicht (130) oder Organosilikatglasschicht 20:1 oder mehr beträgt.

17. Verfahren nach Anspruch 16, wobei das Nassätzen verdünnte HF oder eine Mischung von NH₄F, HF und deionisiertem Wasser verwendet.

18. Verfahren nach einem der Ansprüche 1 bis 17, wobei im Schritt (g) die Zwischenverbindung (210) eine Kupferzwischenverbindung ist.

19. Verfahren nach einem der Ansprüche 1 bis 18, wobei im Schritt (a) die Organosilikatglasschicht (130) unter Verwendung von chemischer Gasphasenabscheidung gebildet wird.

## Revendications

1. Procédé de fabrication d'interconnexions en double damasquinage, le procédé comprenant :
(a) la formation d'une couche diélectrique hybride (130) possédant une constante diélectrique de 3,3 ou moins ou d'une couche de verre en organosilicate sur un substrat (100) et la formation d'une couche de couverture (140) sur la couche diélectrique hybride ou sur la couche de verre en organosilicate ;
(b) la formation d'un via (150) dans la couche de couverture et dans la couche diélectrique hybride ou la couche de verre en organosilicate ;
(c) la formation d'un c remplissage inorganique exempte de carbone ou d'un remplissage basé sur de l'HSQ (160) en utilisant l'enduction centrifuge qui remplit complètement le via et qui est formée sur le couche de couverture à une épaisseur prédéterminée ;
(d) la formation d'un motif photorésistant (185a) sur le remplissage afin de définir une tranchée (190) ;
(e) après la formation du motif photorésistant, l'attaque chimique partielle du remplissage, de la couche de couverture et de la couche diélectrique hybride ou de la couche de verre en organosilicate, afin de former la tranchée (190) par une attaque par voie sèche en utilisant le motif photorésistant comme un masque de gravure de sorte qu'un rapport d'attaque du remplissage par rapport à la couche diélectrique hybride ou à la couche de verre en organosilicate est de 4 : 1 ou inférieur, et de sorte à être ainsi connecté au via ;
(f) l'enlèvement du motif photorésistant et l'enlèvement par une attaque chimique par voie humide du remplissage résiduel dans le via, tout en laissant la couche de revêtement ; et
(g) l'achèvement des interconnexions (210) en formant une couche conductrice sur la structure résultant de l'étape (f) et en planarisant la couche conductrice en utilisant un polissage mécanique chimique pour remplir la tranchée et le via avec du produit d'interconnexion, tandis que la couche de revêtement empêche la couche diélectrique hybride d'être endommagée par le polissage mécanique chimique.

2. Procédé selon la revendication 1 comprenant en outre, avant l'étape (a) :
la formation d'une interconnexion inférieure (110) sur le substrat ; et
la formation d'une couche d'arrêt de l'attaque (120) sur l'interconnexion inférieure.

3. Procédé selon la revendication 2 dans lequel la couche d'arrêt de l'attaque (120) est au moins formée par du SiC, du SiN et du SiCN.

4. Procédé selon l'une quelconque des revendications de 1 à 3 dans lequel la couche diélectrique hybride (130) possédant une constante diélectrique de 3,3 ou moins est une couche de verre en organosilicate.

5. Procédé selon l'une quelconque des revendications de 1 à 4 dans lequel la couche diélectrique hybride (130) possédant une constante diélectrique de 3,3 ou moins est formée en utilisant un dépôt chimique en phase vapeur.

6. Procédé selon l'une quelconque des revendications de 1 à 5 dans lequel la couche de couverture (140) est formée dans un matériau anti-réflectif.

7. Procédé selon l'une quelconque des revendications de 1 à 6 dans lequel la couche de couverture (140) est formée par au moins un matériau parmi le SiO2, le SiOF, le SiON, le SiC, le SiN et le SiCN.

8. Procédé selon l'une quelconque des revendications de 1 à 7 dans lequel l'étape (b) comprend :
la formation d'un motif photorésistant (145) pour définir le via ; et
la formation du via en exposant la couche d'arrêt de l'attaque (120) en attaquant par voie sèche la couche diélectrique hybride (130) ou la couche de verre en organosilicate en utilisant le motif photorésistant (145) comme un masque de gravure.

9. Procédé selon l'une quelconque des revendications de 1 à 8 dans lequel le remplissage inorganique exempte de carbone (160) est un remplissage basé sur de l'HSQ.

10. Procédé selon l'une quelconque des revendications de 1 à 9 dans lequel le remplissage (160) comporte en outre un matériau d'absorption de la lumière et/ou un inhibiteur de dissolution pour une solution développant un produit photorésistant.

11. Procédé selon l'une quelconque des revendications de 1 à 10 comprenant en outre, avant l'étape (d), au moins l'un des processus parmi (i) le traitement de la surface du remplissage (160) en utilisant un plasma, (ii) la formation d'une couche d'anti-réflexion (180) à la surface du remplissage (160), et (iii) le traitement de la surface du remplissage (160) en utilisant un plasma et la formation d'une couche d'anti-réflexion (180) sur la surface du remplissage traitée par le plasma.

12. Procédé selon la revendication 11 dans lequel le plasma est dérivé d'O2, d'H2, d'He, de NH3, de N2, d'Ar ou d'un mélange quelconque de ceux-ci.

13. Procédé selon les revendications 11 ou 12 dans lequel la couche d'anti-réflexion (180) est une couche d'anti-réflexion organique.

14. Procédé selon l'une quelconque des revendications de 11 à 13 dans lequel la couche d'anti-réflexion (180) est formée sur une épaisseur d'environ 50 nm à 70 nm.

15. Procédé selon l'une quelconque des revendications de 1 à 14 dans lequel l'attaque par voie sèche utilise du CxFy ou du CxHyFz en tant que gaz d'attaque principal, et dans lequel l'enlèvement du motif photorésistant (145, 135a) utilise un plasma basé sur de l'H2.

16. Procédé selon l'une quelconque des revendications de 1 à 15 dans lequel l'étape (f) comprend une attaque par voie humide de telle sorte que le rapport d'attaque du remplissage (160) par rapport à la couche diélectrique hybride (130) ou à la couche de verre en organosilicate est de 20 : 1 ou supérieur.

17. Procédé selon la revendication 16 dans lequel l'attaque par voie humide utilise de l'HF dilué ou un mélange de NH4F, d'HF et d'eau dé-ionisée.

18. Procédé selon l'une quelconque des revendications de 1 à 17 dans lequel, dans l'étape (g), l'interconnexion (210) est une interconnexion en cuivre.

19. Procédé selon l'une quelconque des revendications de 1 à 18 dans lequel, dans l'étape (a), la couche de verre en organosilicate (130) est formée en utilisant un dépôt chimique en phase vapeur.
